(19) Europäisches Patentamt

European Patent Office

Office européen des brevets

(11) **EP 1 208 067 B1**

(12) **FASCICULE DE BREVET EUROPEEN**

(45) Date de publication et mention
de la délivrance du brevet:
**02.05.2003 Bulletin 2003/18**

(51) Int Cl.⁷: **C03C 17/245**, C03C 17/34,
B29D 11/00, C23C 14/00

(21) Numéro de dépôt: **00956594.6**

(22) Date de dépôt: **02.08.2000**

(86) Numéro de dépôt international:
**PCT/FR00/02218**

(87) Numéro de publication internationale:
**WO 01/009052 (08.02.2001 Gazette 2001/06)**

(54) **CONDUCTEUR TRANSPARENT ET PROCEDE DE FABRICATION**

TRANSPARENTES LEITERMATERIAL UND VERFAHREN ZUR HERSTELLUNG

TRANSPARENT CONDUCTOR AND MEANS FOR MAKING SAME

(84) Etats contractants désignés:
**AT BE CH CY DE DK ES FI FR GB GR IE IT LI LU MC NL PT SE**

(30) Priorité: **03.08.1999 FR 9910074**

(43) Date de publication de la demande:
**29.05.2002 Bulletin 2002/22**

(73) Titulaire: **COMMISSARIAT A L'ENERGIE ATOMIQUE**
**75752 Paris Cédex 15 (FR)**

(72) Inventeurs:
• **BOY, Philippe**
**F-37300 Joue les Tours (FR)**
• **COQUARD, Pierre**
**F-37250 Veigne (FR)**
• **MANAUD, Jean-Pierre**
**F-33450 Saint Loubes (FR)**
• **SALARDENNE, Jean**
**F-33600 Pessac (FR)**
• **WARTENBERG, Isabelle**
**F-37260 Monts (FR)**
• **MARCEL, Corinne,**
**Résidence "Jardins de la Somme"**
**80000 Amiens (FR)**

(74) Mandataire: **Audier, Philippe André et al**
**Brevatome,**
**3, rue du Docteur Lancereaux**
**75008 Paris (FR)**

(56) Documents cités:
EP-A- 0 500 445         FR-A- 2 683 219
US-A- 4 248 687

• SALARDENNE J ET AL: "Electron scattering mechanisms in ITGO (Sn+Ge doped In/sub 2/O/sub 3/) thin films for low emittance window coatings" EUROPEAN PHYSICAL JOURNAL, APPLIED PHYSICS, 1998, EDP SCIENCES, FRANCE, vol. 3, no. 3, pages 233-235, XP002135479 ISSN: 1286-0042

**Description**

**Domaine technique**

La présente invention se rapporte à un film conducteur transparent à base d'oxydes d'indium, d'étain et de germanium (ITGO), à un produit comprenant un substrat recouvert au moins en partie d'un tel film conducteur et pouvant comprendre en outre une couche de silice sur ledit film, et à un procédé de fabrication dudit produit.

Les films conducteurs transparents de la présente invention sont une catégorie importante de matériaux optiques. Leurs applications concernent de nombreux domaines de l'électro-optique tels que l'affichage, les dispositifs électrochromes, les fenêtres chauffantes, les cellules solaires. Les produits pouvant être fabriqués selon l'invention peuvent être également un vitrage, une protection électromagnétique par exemple un écran hyperfréquence.

En général, on recherche pour ce type de film une bonne transparence visible tout en conservant une conductivité élevée pour pouvoir travailler sur des surfaces assez grandes.

Les films de la présente invention, appelés aussi matériaux conducteurs transparents ou films transparents, sont généralement sous la forme de couches minces. Ils peuvent être déposés sur des substrats constitués de polymère. Les avantages des dépôts sur polymères sont nombreux. Parmi ceux-ci, on peut citer le coût moindre du substrat, le gain de poids, une plus grande facilité à réaliser des dépôts en continu, la plus grande résistance mécanique du substrat ou support et la possibilité de revêtir des formes complexes.

Certaines applications demandent la réalisation de films transparents dans la fenêtre d'émission du soleil, c'est-à-dire 0,3 à 3 $\mu$m.

Par exemple, les fenêtres froides utilisées dans l'aéronautique et le bâtiment sont des vitrages qui laissent passer le rayonnement solaire et réfléchissent l'infrarouge au-delà de 3 $\mu$m, de façon à confiner, dans un espace clos, la chaleur d'origine radiative. Dans cette application, le film doit présenter une conductivité la plus élevée possible tout en conservant une grande transparence en dessous de 3 $\mu$m.

Un autre exemple d'application est constitué par les cellules solaires, destinées à transformer le rayonnement provenant du soleil en énergie électrique. Elles sont constituées d'un semi-conducteur absorbeur d'énergie et d'un matériau conducteur transparent qui assure la jonction et le transport électronique. La bonne efficacité de la cellule est liée à la transparence du conducteur au rayonnement solaire et à sa conductivité.

**Art antérieur**

Que l'on désire travailler dans le visible ou dans la fenêtre solaire, il apparaît nécessaire de mettre au point des matériaux toujours plus fortement conducteurs ($\sigma$>1000 S/cm) et présentant une grande transparence entre 0,3 et 3 $\mu$m donc en particulier dans le visible.

Pour atteindre ce résultat, plusieurs paramètres doivent être pris en compte :

- l'épaisseur, t, du film : le facteur de transmission est d'autant plus élevé que l'épaisseur de la couche est faible ; généralement, elle ne doit pas dépasser 500 nm ;
- la conductivité ou la résistivité du film : plus la résistivité est faible, plus la couche est conductrice et plus la résistance carrée $R_S$ (rapport de la résistivité sur l'épaisseur) est petite ; or, plus $R_S$ diminue, plus la réflectivité dans l'infrarouge augmente ; on cherche généralement des résistances carrées inférieures à 20 $\Omega$/ ;
- la longueur d'onde de coupure, $\lambda_{R=T}$, entre grande transmittivité et grande réflectivité : pour obtenir des transparences élevées dans une fenêtre optique plus grande, il faut diminuer le nombre de porteurs de charge, ce qui se traduit, à épaisseur constante, par une augmentation de la résistivité et donc de la résistance surfacique.

Dans le domaine technique considéré, le conducteur transparent le plus utilisé est l'Oxyde d'Indium dopé à l'Étain (ITO). Par exemple, pour avoir une longueur d'onde de coupure proche de 3 $\mu$m avec un matériau tel que l'ITO, il faut une conductivité, $\sigma$<500 S/cm, qui conduit à des niveaux de réflectivité trop faibles. Il apparaît qu'avec les matériaux de l'art antérieur de type ITO, on ne peut moduler indépendamment la transmission dans le visible, la réflexion dans l'IR et la longueur d'onde de coupure.

Par exemple, on ne peut pas obtenir les conditions idéales qui permettraient d'avoir une transparence jusqu'à 3 $\mu$m et une réflectivité de plus de 80%.

Les conditions optimales pour atteindre cet objectif sont :

- N=1-2.10$^{21}$ at/cm$^3$ (N=nombre de porteurs. de charges)
- $\mu$=60 cm$^2$V$^{-1}$s$^{-1}$ ($\mu$=mobilité des porteurs de charges)
- R =1+-20 $\Omega$/ (R est identique à $R_S$, la résistance carrée).

Dans le tableau ci-dessous sont reportés les meilleurs ITO élaborés par différentes techniques de dépôt sous vide.

Tableau 1

| Pulvérisation magnétron DC ou RF | Evaporation électronique ou thermique | Evaporation réactive activée | CVD | Ablation laser |
|---|---|---|---|---|
| $T_{vis} \approx 0,9$ | $T_{vis} \approx 0,85$ | $T_{vis} \approx 0,85$ | $T_{vis} \approx 0,9$ | $T_{vis} \approx 90\%$ |
| $R_{max} = 0,93$ | $R \approx 0,9\%$ (1>5 µm) | $R_{max} > 0,8$ | $R \approx 20$ W/ | $R \approx 20$ W/ |
| $\lambda_c = 1,8$ µm | $\lambda_C = 1,5$ µm | -- | -- | $\lambda_C > 1$ µm |
| e=300 nm | e=120 nm | -- | e=270 nm | e=150 nm |
| $T_{vis}$ : transmittance dans la fenêtre visible<br>$R_{max}$ : réflectance maximale observée au-delà de 3 µm<br>$\lambda_c$ : longueur d'onde de coupure entre grande transmittance et forte réflectance<br>e : épaisseur du film. | | | | |

La pulvérisation magnétron DC ou RF est une technique décrite par exemple dans J.C.C. Fan et F.J. Bachner : "Properties of Sn-doped $In_2O_3$ films prepared by R.F.-sputtering", J. Electrochem. Soc.: Solid-State Science and Technology, 1975, 122 (12), p. 1719, l'évaporation électronique ou thermique est une technique décrite par exemple dans I. Hamberg, C.G. Granqvist, K.F. Berggren, B.E. Sernelius et L. Engström : "Optical properties of transparent and infrared-reflecting ITO films in the 0,2-50 µm range" ; Vacuum, 1985, 35(6), p. 207, l'évaporation réactive activée est une technique décrite par exemple dans J. Kane, H.P. Schweizer et W. Kern, "Chemical Vapor Deposition of transparent electrically conducting layers of Indium Oxide doped with Tin" ; Thin Solid Films, 1975, 29, p. 155, le dépôt CVD est une technique décrite par exemple dans J.P. Zheng et H.S. Kwok ; Appl. Phys. Lett., 1993, 63, p. 1 et l'ablation laser est une technique décrite par exemple dans J.P. Zheng and H.S. Kwok ; "Préparation of indium tin oxide films at room température by pulsed laser deposition", Thin Solid Films, 1993, 232, P. 99.

Avec les techniques décrites ci-dessus, les meilleures propriétés optiques de l'ITO sont généralement obtenues sur des substrats de type verre et à des températures dépassant les 300°C. Ces conditions de dépôts ne sont pas extrapolables sur des substrats polymères en raison de leur faible tenue aux contraintes thermiques. Par conséquent, il est difficile de retrouver, sur polymère, les qualités optiques des films d'ITO déposés sur verre.

On peut remplacer l'activation thermique des dépôts par une activation ionique ou plasma par exemple par les techniques suivantes :

- évaporation assistée du canon ion,
- évaporation activée par plasma,
- dépôt chimique en phase vapeur activée par plasma.

Le dépôt sur verre de tels films par des techniques pose notamment les problèmes suivants liés à la nature du substrat : coût et poids élevés, fragilité, difficulté de réaliser des formes complexes, difficulté à réaliser des dépôts en continu.

Un autre exemple de matériau est l'oxyde d'Indium dopé à l'Etain et au Germanium (ITGO). L'ITGO possède une fenêtre de transparence plus importante que les oxydes conducteurs transparents classiques tels que $In_2O_3$:Sn, ZnO:Ga, ZnO:Al et $SnO_2$:F à conductivité égale. Ceci provient du fait que l'introduction d'un deuxième dopant crée un degré de liberté supplémentaire dans le processus d'optimisation. On peut ainsi moduler plus facilement les propriétés des films minces en fonction des application recherchées.

Par exemple, le document FR-A-2 683 219 décrit une couche mince conductrice d'ITGO sur verre. Mais cette couche ne présente pas les propriétés électro-optiques requises.

Les techniques de l'art antérieur proposent aussi des empilements transparents visibles et réflecteurs IR, généralement assez complexes, avec des oxydes ne possédant pas de propriétés électriques particulières.

D'autres techniques encore concernent la réalisation d'empilements Silice/ITO sur verre ou polymère.

**Exposé de l'invention**

La présente invention a précisément pour but de palier les problèmes précités, en fournissant un film conducteur transparent, présentant notamment une transparence entre 0,3 et 3 µm, une conductivité σ>1000 S/cm suffisante pour travailler même sur de grandes surfaces supérieures à 100 cm$^2$, et pouvant être déposé sur un substrat de polymère transparent thermostable à 300°C ou non.

Le film conducteur transparent de la présente invention est un film à base d'oxyde d'indium (InO$_2$) d'oxyde d'étain (SnO$_2$) et d'oxyde de germanium (GeO$_2$) appelé aussi ITGO, dans lequel le rapport des concentrations en poids de SnO$_2$ sur GeO$_2$ dans le film est d'environ 1 à 10, de préférence environ égal à 5, et dans lequel de préférence d'oxyde d'étain représente d'environ 0,5% à environ 10% en poids dans le film, et l'oxyde de germanium représente d'environ 0,1 à environ 5% en poids dans le film.

Selon l'invention, de préférence, la concentration en SnO$_2$ est de 0,5 à 2,5% en poids et la concentration en GeO$_2$ est de 0,1 à 0,5% en poids, le reste étant de l'oxyde d'indium et des impuretés inévitables.

La présente invention fournit également un produit comprenant un substrat recouvert au moins en partie d'un film conducteur transparent d'ITGO dans lequel le film conducteur transparent est un film conducteur transparent selon la présente invention.

Selon l'invention, le substrat peut être par exemple un substrat de polymère thermostable à 300°C, permettant notamment de travailler lors du dépôt du film sur le substrat à une température de 250 à 300°C tel qu'un polyimide (PI), la poly(éther-éther-cétone) (PEEK) semi-cristallisée ; ou par exemple un polymère non thermtostable tel que le polyéthylène téraphtalate (PET), etc... Le substrat du produit selon l'invention peut avoir une surface quelconque, par exemple d'au moins 10x10 cm$^2$.

Le produit selon l'invention peut être un produit électro-optique tels que par exemple ceux précités.

Selon l'invention, le film conducteur transparent peut avoir une épaisseur supérieure à 400 nm et inférieure ou égale à 1000 nm, par exemple de 400 à 500 nm.

Selon l'invention, le produit peut comprendre en outre une couche de protection de type oxyde transparent diélectrique ayant un indice de réfraction plus faible que celui de l'ITGO dans la gamme de 0,3 à 3 $\mu$m, par exemple une couche de silice (SiO$_2$). L'épaisseur de la couche peut être de 0,05 à 0,5 $\mu$m, de préférence voisine de 0,1 $\mu$m.

La couche de protection peut être constituée d'un oxyde de métal de transition tel que ZrO$_2$, Al$_2$O$_3$, HfO$_4$, TiO$_2$, etc... Ce sont des matériaux isolants électriques. Il y a ceux qui ont un indice de réfraction plus faible que l'ITGO dans la gamme de longueur d'onde précitée, et ceux qui ont un indice plus élevé. Les premiers jouent un rôle d'antireflet et les seconds un rôle de réflecteurs.

Lorsque le produit de la présente invention comprend une couche de silice (SiO$_2$), celle-ci peut avoir par exemple une épaisseur d'environ 0,1 $\mu$m, ce qui correspond à un effet antireflet optimum à 0,7-0,8 $\mu$m, c'est-à-dire le maximum d'émission du soleil.

La présente invention se rapporte également à un procédé de fabrication d'un produit selon l'invention dans lequel le film d'oxydes d'indium, d'étain et de germanium est déposé sur le substrat par une technique de dépôt physique en phase vapeur (PVD).

Selon l'invention, lorsque le produit selon l'invention comprend en outre une couche de silice, celle-ci peut être déposée également par une technique de dépôt PVD.

La technique de dépôt PVD peut être réalisée au moyen de tout appareil standard permettant le dépôt de matériaux en couches minces par exemple par pulvérisation ou par évaporation.

La technique par pulvérisation peut être par exemple une technique par pulvérisation magnétron RF (dépôt à haute température) et la technique par évaporation peut être par exemple une technique d'évaporation réactive activée (ERA) ou dépôt ionique qui permet de réaliser des dépôts à basse température. Ces techniques sont bien connues par l'homme du métier et sont décrites par exemple dans les deux documents cités pour ces techniques pour le tableau 1 ci-dessus.

De nombreux avantages de la présente invention apparaîtront à l'homme du métier dans la description et les exemples qui suivent, en référence aux dessins en annexe, donnés bien entendu à titre illustratif et non limitatif.

**Description de l'invention**

Le procédé qui fait l'objet de l'invention consiste à déposer, par des techniques PVD, sur tout type de substrat, un film constitué d'un matériau conducteur transparent appartenant à la famille de l'oxyde d'indium dopé à l'étain, l'ITGO (Oxyde d'Indium dopé à l'Etain et au Germanium) et éventuellement sur ce film une couche de silice ou tout autre oxyde transparent. Le film de silice assure la protection du film conducteur transparent : en effet, les composés de la famille de l'ITO sont des oxydes non stoechiométriques, ce qui les rend sensibles, en particulier, à l'humidité et, en général, aux atmosphères agressives. Cette couche de silice ne doit pas, cependant, perturber les propriétés optiques. Comme son indice est plus faible que celui de l'ITGO, SiO$_2$ a également une double fonction optique : elle joue le rôle de couche antireflet dans la fenêtre visible et elle déplace la longueur d'onde de coupure dans l'infrarouge.

Film conducteur transparent

Les meilleurs dopants des oxydes conducteurs transparents sont des éléments de taille équivalente à celle de l'atome hôte et possédant des électrons supplémentaires susceptibles d'assurer une conduction de type n. Le dopage se limite essentiellement à l'élément immédiatement à droite de cet atome et à celui au-dessus ou au-dessous dans le tableau périodique.

Comme on introduit des impuretés ionisées, on augmente les phénomènes de diffusion, défavorable à la mobilité mais également à la transparence. Cependant, au bilan, on améliore de façon importante la conductivité des films par rapport au composé non dopé. Ainsi, l'oxyde d'indium dopé à l'étain (ITO) est le conducteur transparent le plus utilisé. Mais si on ajoute également du germanium, dopant un peu moins efficace, on observe un comportement tout à fait intéressant que ce soit pour des applications dans le visible ou dans le solaire :

- pour les applications électro-optiques, à dopage équivalent en Sn, mais en rajoutant une petite quantité de germanium, on augmente la conductivité par rapport à l'ITO classique. La réflectivité dans le proche infrarouge est donc améliorée, sans modifier la transmittance ; par contre, on diminue légèrement la fenêtre de transparence,
- pour des applications thermo-optiques, on obtient des niveaux de conductivité élevés avec un taux de dopage (Sn et Ge) beaucoup plus faible que pour l'ITO classique.

Le fait de rajouter du germanium dans de l'oxyde d'indium dopé à l'étain permet d'améliorer la mobilité, $\mu$, des porteurs de charge. On a besoin d'une concentration N de ces porteurs et, par suite, d'un taux de dopage plus faible pour obtenir la même conductivité dans ITGO que dans l'ITO. D'après le modèle de Drude d'oscillation de plasma des électrons libres, on augmente ainsi la longueur d'onde de coupure :

$$\lambda p = 2\pi c \left( \frac{\varepsilon 0 \varepsilon \infty m^*}{Ne^2} \right)^{1/2}$$

avec m* = masse effective.

On élargit ainsi la fenêtre optique de ce matériau tout en conservant la même conductivité puisque $\sigma = Ne\mu$. Par ailleurs, le front de montée de la réflectivité au voisinage de $\lambda p$ dépend de l'énergie de dispersion $E\tau = \frac{\eta}{\tau}$ où $\tau$ est le temps moyen séparant deux collisions successives avec un défaut de réseau (impureté ou phonon) pour un même électron. L'augmentation de $\tau$ permet de diminuer l'énergie de dispersion et de conserver le caractère abrupt de la limite basse fréquence de la fenêtre optique.

A l'observation des spectres, on remarque que $\tau$ varie peu entre ITO et ITGO. L'accroissement de mobilité, $\mu = \frac{e\tau}{m^*}$, par addition de Ge, est donc dû essentiellement à la diminution de m*.

La composition de l'ITGO de la présente invention montre que le rapport préféré entre le taux de dopage en étain et celui en germanium est d'environ 5.

Les inventeurs ont étudié plusieurs concentrations d'étain et de germanium dans l'ITGO de façon à avoir des fenêtres de transparence jusqu'à 2 μm, voire au-delà.

Les inventeurs ont utilisé des méthodes PVD telles que pulvérisation et évaporation pour réaliser des films minces sur polymère ou sur verre. Ces techniques permettent d'obtenir des dépôts denses présentant d'excellentes qualités optiques tout en travaillant à des températures compatibles avec tous les substrats.

Dans les exemples qui suivent, les inventeurs démontrent les résultats obtenus en utilisant deux de ces techniques : la pulvérisation cathodique diode RF et l'évaporation réactive activée qui est une des variantes du dépôt ionique ou "Ion Plating". Ils démontrent qu'en pulvérisation diode RF la température de substrat nécessaire à l'obtention de bonnes propriétés optiques pour les films reste élevée (au moins 250°C) ce qui limite l'utilisation de cette technique à des verres ou des polymères thermostables.

Pour les substrats non thermostables tels que certains polymères, les inventeurs démontrent que les techniques variées utilisant une assistance par bombardement ionique lors de la croissance du dépôt sont bien adaptées à ce problème. En effet, la faible profondeur de pénétration des ions utilisés permet de confiner le surcroît d'énergie fourni à la surface de la couche en cours de croissance et de limiter ainsi l'échauffement du substrat. Par ailleurs, ils montrent que certaines techniques permettent un réglage séparé des paramètres contrôlant la vitesse de dépôt, d'une part, et l'énergie de recristallisation, d'autre part, d'où une meilleure optimisation des conditions de croissance de la couche mince.

En ce qui concerne la couche de silice, les inventeurs démontrent dans les exemples suivants que les techniques par évaporation assistée ou non ou la pulvérisation sont bien adaptées quel que soit le substrat.

*Exemples : résultats expérimentaux*

Les tableaux 2 à 4 suivants décrivent des exemples de conditions de dépôt selon l'invention du film ITGO et de la couche de silice sur un substrat de polymère et pour comparaison sur un substrat de verre pour les principales techniques de dépôts PVD.

Tableaux 2 à 4

Conditions expérimentales qui peuvent être utilisées pour réaliser des dépôts d'ITGO selon l'invention par pulvérisation et évaporation

Tableaux 2 et 3 : Dépôt d'ITGO

Tableau 2

| Technique | Pulvérisation RF | Evaporation assistée par plasma |
|---|---|---|
| Substrat | Verres, polymères thermiquement stable (jusqu'à 350°C) | Verres, polymères à faible tenue thermique (T<100°C) |
| Composition de la cible (en % en poids) | 0,1 à 2% Ge et 0,5 à 10% Sn | 0,1 à 2% Ge et 0,5 à 10% Sn |
| Pression de process | $10^{-3}$ à $10^{-2}$ mbar | $10^{-3}$ à $10^{-2}$ mbar |
| Densité de puissance RF | 0,1 à 4 W/cm$^2$ | 0 à 1 W/cm$^2$ |
| Puissance canon à électrons | | 0 à 1 kW |
| Pression partielle d'oxygène | 0 à 5% | 0 à 100% |
| Température du substrat | de l'ambiante à 350°C | de l'ambiante à 100°C |
| Taille des substrats | 2x2 cm$^2$ à 100x100 cm$^2$ | 2x2 cm$^2$ à 100x100 cm$^2$ |

Tableau 3

| Technique | Evaporation électronique | Evaporation assistée par canon à électrons |
|---|---|---|
| Substrat | Verres, polymères thermiquement stable (jusqu'à 350°C) | Verres, polymères à faible tenue thermique (T < 100°C) |
| Composition de la cible (en % en poids) | 0,1 à 2% Ge et 0,5 à 10% Sn | 0,1 à 2% Ge et 0,5 à 10% Sn |
| Pression de process | <$10^{-4}$ mbar | <$10^{-4}$ mbar |
| Puissance canon à électrons | 0 à 1 kW | 0 à 1 kW |
| Pression partielle d'oxygène canon à ions | 0 à 100% | 0 à 100% |
| Température du substrat | de l'ambiante à 350°C | de l'ambiante à 100°C |
| Intensité canon à ions | | 0 à 5 mA/cm$^2$ |
| Potentiel canon à ions | | 50 à 300 V |
| Taille des substrats | 2x2 cm$^2$ à 100x100 cm$^2$ | 2x2 cm$^2$ à 100x100 cm$^2$ |

Tableau 4 :

| dépôt de silice | | |
|---|---|---|
| Technique | Pulvérisation RF | Evaporation assistée par plasma |
| Substrat | Verres, polymères thermiquement stable (jusqu'à 350°C) | Verres, polymères à faible tenue thermique (T<100°C) |
| Composition de la cible | $SiO_2$ | $SiO_2$ |
| Pression de process | $10^{-3}$ à $10^{-2}$ mbar | $< 10^{-4}$ mbar |
| Densité de puissance RF | 0,1 à 4 W/cm$^2$ | 0 à 1 W/cm$^2$ |
| Pression partielle d'oxygène | 0 à 5% | 0 à 100% |
| Densité de puissance RF | 0 à 5 W/cm$^2$ | 0 à 2 W/cm$^2$ |
| Intensité canon à ions | | 0 à 5 mA/cm$^2$ |
| Température du substrat | de l'ambiante à 350°C | de l'ambiante à 100°C |
| Taille des substrats | 2x2 cm$^2$ à 100x100 cm$^2$ | 2x2 cm$^2$ à 100x100 cm$^2$ |

Les conditions opératoires sont données pour la silice, mais elles sont les mêmes pour tout oxyde transparent diélectrique ayant un indice de réfraction plus faible que celui de l'ITGO dans la gamme des 0,3 à 3 μm. Un tel empilement permet d'améliorer les propriétés optiques de l'ITGO déposé sur verre et polymère par ajout d'une couche de protection de type oxyde transparent ayant un indice de réfraction plus faible. La fenêtre de transparence ainsi que la transmission totale sont plus grandes qu'avec l'ITGO tout seul. Des applications dans le domaine du vitrage et de la protection électromagnétique sont tout à fait appropriées.

## AUTRES EXEMPLES

La pulvérisation RF

*les machines*

Tout appareil standard permettant le dépôt de matériaux en couches minces par pulvérisation RF, de préférence magnétron, peut être utilisé pour la préparation des couches.

*les substrats*

Il s'agit de substrat verre de type BK7 de la société EUROPTICS pour comparaison ou de polymères thermostables qui permettent de travailler jusqu'à 250-300°C tels qu'un polyimide (PI), la poly(éther-éther-cétone) (PEEK) semi-cristallisée. Ce sont des polymères transparents ou semi-transparents.

Dépôts d'ITGO

*les cibles*

Il s'agit de cibles d'ITGO frittées avec les compositions suivantes : 1% $SnO_2$/0,2% $GeO_2$, 2,5% $SnO_2$/0,5% $GeO_2$ ou 0,5% $SnO_2$/0,1% $GeO_2$. Les deux premières compositions sont dénommées respectivement ITGO 1 et ITGO 2 dans la suite du texte. On peut remarquer que les propriétés optiques des films sont légèrement différentes selon la technique employée, c'est-à-dire pulvérisation ou évaporation.

*les paramètres de dépôt*

En pulvérisation magnétron RF, on peut faire varier la température du substrat, la puissance RF, la tension d'autopolarisation, la pression dans l'enceinte, les pressions partielles d'oxygène et la vitesse de dépôt. La plupart de ces paramètres ont été établis pour un substrat de verre : il s'agit de la pression d'argon ($10^{-3}$ à $10^{-2}$ mbar), de la pression partielle d'oxygène (0,1 à 5%), de la puissance RF (1 à 2 W/cm$^2$), de la tension d'autopolarisation et de la température (350°C sur verre et 250°C à 320°C sur polymère).

Un certain nombre de résultats sont reportés dans le tableau 5 suivant.

Tableau 5

| Films d'ITGO déposés sur polymères et sur verre par pulvérisation magnétron RF | | | | | |
|---|---|---|---|---|---|
| N° Echantillon | Conditions de préparation | Epaisseur (nm) | Mobilité $(cm^2/V-S)$ | Porteurs de charge $(cm^{-3})$ | Résistivité $(\Omega cm)$ |
| 1 (sur PI) ITGO 1 | 320°C/17,5W/ 1Pa/220V | 500 | 52 | $9,36.10^{19}$ | $1,28.10^{-3}$ |
| 2 (sur PI) ITGO 1 | 300°C/22,5W/ 1Pa/250V | 1000 | 38 | $1,82.10^{20}$ | $9,15.10^{-4}$ |
| 3 (sur PI) ITGO 1 | 280°C/22,5W/ 1Pa/250V | 500 | 30 | $1,54.10^{20}$ | $1,35.10^{-3}$ |
| 6 (sur PEEK) ITGO 1 | 300°C/20W/ 1Pa/230V | 500 | 40 | $1,29.10^{20}$ | $1,21.10^{-3}$ |
| ITGO1 (sur verre) | 350°C/22,5W/ 1Pa/230V | 650 | 57 | $2,8.10^{20}$ | $3,9.10^{-4}$ |
| ITGO2 (sur verre) | 350°C/22,5W/ 1Pa/230V | 500 | 61 | $1,7.10^{20}$ | $7.10^{-4}$ |
| Notation : PI = polyimide PEEK = poly(éther-éther-cétone) | | | | | |

Les résultats suivants du tableau 6 permettent de faire la comparaison des performances optiques et électriques des ITGO de la présente invention réalisés sur verre et sur polymère.

Tableau 6

| N° échantillon | T à 0,8 µm | R (20 µm) | Conductivité S/cm | 1 (R=T | T polymère à 0,8 µm |
|---|---|---|---|---|---|
| ITGO 1 | 0,85 | 0,92 | 2488 | 2 | -- |
| ITGO 2 | 0,89 | 0,86 | 1488 | 2,7 | -- |
| 1 | - | 0,65 | 780 | 2,2 | 0,79 |
| 2 | -- | - | 1093 | -- | 0,79 |
| 3 | -- | 0,62 | 741 | - | 0,79 |
| 6 | - | 0,68 | 826 | -- | 0,87 |

Les (--) correspondent à des mesures non effectuées.

Ainsi, la pulvérisation magnétron RF ne nous a pas permis d'obtenir les mêmes qualités de dépôts sur polymère que sur verre. En effet, les meilleurs films sont obtenus pour des températures de substrats supérieures à 300 (350°C) incompatibles avec les polymères utilisés.

Dépôts de silice

Les inventeurs ont choisi de déposer de la silice comme couche de protection antireflet. Il s'agit d'un oxyde qui a un indice de réfraction bas autour de 1,5. Les dépôts de $SiO_2$ sont réalisés par pulvérisation RF réactive à une température proche de l'ambiante en utilisant une cible de silice fondue. L'épaisseur de la couche ne varie pas d'un échantillon à l'autre. Elle est d'environ 0,1 µm, ce qui correspond à un effet antireflet optimum à 0,7-0,8 µm, c'est-à-dire le maximum d'émission du soleil.

# EP 1 208 067 B1

Empilement ITGO/SiO$_2$ sur substrats verre et polymère

Les inventeurs ont utilisé des cibles de diamètre 75 mm : SiO$_2$ fondue, ITGO 2,5% SnO$_2$/0,5 GeO$_2$ et ITGO 1% SnO$_2$/0,2% GeO$_2$ frittées. Les conditions expérimentales et les performances optiques des différents empilements ITGO/SiO$_2$ sont résumés dans les tableaux 7 et 8 suivants.

T$_{sol}$ est la transmission solaire intégrée, c'est-à-dire la transmission moyenne de l'empilement par rapport au spectre d'émission du soleil :

$$T_{sol} = \frac{\int_{-\infty}^{+\infty} T(\lambda)E(\lambda)d\lambda}{\int_{-\infty}^{+\infty} E(\lambda)d\lambda}$$

avec T($\lambda$), la transmittivité de l'empilement à la longueur d'onde $\lambda$ et E($\lambda$), l'émissivité du soleil à la même longueur d'onde.

Tableau 7

| empilement SiO$_2$/ITGO 1%Sn/0,2%Ge | | | | |
|---|---|---|---|---|
| Substrat | Verre | | PEEK | |
| Epaisseur ITGO | 560 | | 560 | |
| Conditions de dépôts | 0,2%O$_2$/350°C/5.10$^{-3}$mbar/1,5W. cm$^{-2}$ | | 0,2%O$_2$/225°C/5.10$^{-3}$mbar/1,5W. cm$^{-2}$ | |
| Vitesse de dépôt | 0,25 nm/s | | 0,25 nm/s | |
| Epaisseur SiO$_2$ | 100 nm | | 100 nm | |
| Conditions de dépôts | sans chauffage/5.10$^{-3}$mbar/1,5W.cm$^{-2}$ | | sans chauffage/5.10$^{-3}$mbar/1,5W.cm$^{-2}$ | |
| Vitesse de dépôt | 0,07 nm/s | | 0,07 nm/s | |
| | ITGO | ITGO/SiO$_2$ | ITGO | ITGO/SiO$_2$ |
| R(10 µm) | 0,86 | 0,85 | 0,72 | 0,76 |
| T(0,8 µm) | 0,85 | 0,88 | 0,77 | 0,78 |
| T$_{sol}$ | 76,1% | 77,7% | 65,8% | 68,7% |
| $\lambda_{(R=T)\mu m}$ | 2,6 | 2,7 | 2,9 | 3,3 |

Tableau 8

| empilement SiO$_2$/ITGO 2,5%Sn/0,5%Ge | | | | |
|---|---|---|---|---|
| Substrat | Verre | | PEEK | |
| Epaisseur ITGO | 575 nm | | 575 nm | |
| Conditions de dépôts | 0,2%O$_2$/350°C/5.10$^{-3}$mbar/ 1,5W.cm$^{-2}$ | | 0,2%O$_2$/350°C/5.10$^{-3}$mbar/ 1,5W.cm$^{-2}$ | |
| Vitesse de dépôt | 0,29 nm/s | | 0,29 nm/s | |
| Epaisseur SiO$_2$ | 100 nm | | 100 nm | |
| Conditions de dépôts | sans chauffage/5.10$^{-3}$mbar/1,5W.cm$^{-2}$ | | sans chauffage/5. 10$^{-3}$mbar/1,5W.cm$^{-2}$ | |
| Vitesse de dépôt | 0,07 nm/s | | 0,07 nm/s | |
| | ITGO | ITGO/SiO$_2$ | ITGO | ITGO/SiO$_2$ |
| R(10 µm) | 0,93 | 0,94 | 0,80 | 0,86 |
| T(0,8 µm) | 0,9 | 0,9 | 0,73 | 0,81 |

Tableau 8  (suite)

| empilement SiO$_2$/ITGO 2,5%Sn/0,5%Ge | | | | |
|---|---|---|---|---|
| Substrat | Verre | | PEEK | |
| T$_{sol}$ | 72,4% | 74,5% | - | 68,1% |
| $\lambda_{(R=T)}(\mu m)$ | 1,8 | 2,2 | 2,8 | 3 |

Le fait de rajouter une couche de silice a un double effet.

D'une part, une augmentation de la transmission solaire intégrée,

D'autre part, $\lambda_{R=T}$ se déplace vers les grandes longueurs d'onde,

Cependant, les performances des films déposés sur PEEK sont sensiblement moins bonnes que celles des dépôts sur verre.

D'un autre côté, l'amélioration des propriétés optiques du film d'ITGO après dépôt de la silice est plus sensible quand le substrat est un polymère.

## Evaporation électronique et plasma

En utilisant la technique d'évaporation réactive activée, les inventeurs ont réalisé des dépôts sur polymère présentant les mêmes performances que ceux réalisés sur verre par la même technique.

Le principe de cette technique est le suivant : on évapore le matériau à déposer grâce à un canon. Un plasma d'argon ou d'oxygène est créé puis accéléré par polarisation RF du porte substrat. Ce dernier va, en particulier, ioniser les molécules évaporées. Les particules arrivant sur le substrat sont alors plus énergétiques. Théoriquement, on a une meilleure adhésion et une densification de la couche par les molécules d'argon ou d'oxygène. Dans la présente invention, on peut même espérer avoir une meilleure efficacité de dopage à condition d'avoir un plasma peu énergétique.

### Les substrats

Les inventeurs ont effectué en même temps, un dépôt sur PET (polyéthylène téraphtalate) (2,5x2,5 cm$^2$) ou sur PEEK et un dépôt sur verre pour comparaison. Etant donné la taille de la cible, il a été difficile d'obtenir des dépôts homogènes sur les deux substrats.

### Dépôts d'ITGO

Les tableaux 9 à 11 ci-dessous résument les différentes expériences réalisées par les inventeurs avec cette technique, en fonction de différents paramètres de dépôt.

Tableau 9

| Influence de la pression partielle d'oxygène (pression totale : 10$^{-3}$ mbar) | | | | | | | |
|---|---|---|---|---|---|---|---|
| | | | ITGO sur verre | | ITGO sur polymère | | |
| Puissance W | %O$_2$ | Epaisseur A (verre) | Résistivité ($\Omega$cm) | T(0,8 $\mu$m) | Résistivité ($\Omega$cm) | T à 0,8 $\mu$m (et polymère seul) | $\lambda_{(R=T)}\mu m$ |
| 40 | 20 | 2975 | 1,5.10$^{-3}$ | 0,75 | 1,4.10$^{-3}$ | 0,76(0,87) | 2,3 |
| 40 | 30 | 3640 | 1,2.10$^{-3}$ | 0,76 | 10$^{-3}$ | 0,76(0,87) | 2,3 |
| 40 | 40 | 3140 | 1,8.10$^{-3}$ | 0,80 | 1.6.10$^{-3}$ | 0,74(0,87) | 2,9 |
| 200 | 20 | 4750 | 1,5.10$^{-3}$ | 0,66 | 1.5.10$^{-3}$ | 0,69(0,87) | 2,1 |
| 200 | 10 | 6130 | 0,7.10$^{-3}$ | faible | 0,8.10$^{-3}$ | détérioré | -- |
| 250 | 40 | 3700 | 4,1.10$^{-3}$ | 0,87 | 4,1.10$^{-3}$ | 0,69(0,87) | 4 |
| 250 | 20 | 3400 | 2,3.10$^{-3}$ | -- | 2,5.10$^{-1}$ | 0,65(0,87) | 3,1 |
| 150 | 10 | 3000 | 2,5.10$^{-3}$ | | 2,1.10$^{-3}$ | 0,71(0,87) | 2,6 |
| 150 | 15 | 3730 | 2,4.10$^{-3}$ | | 2,1.10$^{-3}$ | | |

Tableau 9   (suite)

| Influence de la pression partielle d'oxygène (pression totale : $10^{-3}$ mbar) | | | | | | | |
|---|---|---|---|---|---|---|---|
| | | | ITGO sur verre | | ITGO sur polymère | | |
| Puissance W | %$O_2$ | Epaisseur A (verre) | Résistivité ($\Omega$cm) | T(0,8 $\mu$m) | Résistivité ($\Omega$cm) | T à 0,8 $\mu$m (et polymère seul) | $\lambda_{(R=T)\mu m}$ |
| 150 | 20 | 3400 | $1,8.10^{-3}$ | | NM | | |

Tableau 10

| Influence de la puissance RF (pression totale : $10^{-3}$ mbar) | | | | | | | |
|---|---|---|---|---|---|---|---|
| | | | ITGO sur verre | | ITGO sur polymère | | |
| Puissance W | %$O_2$ | Epaisseur A (verre) | Résistivité ($\Omega$cm) | T(0,8 $\mu$m) | Résistivité ($\Omega$cm) | T (0,8 $\mu$m) (et polymère seul) | $\lambda_{(R-T)\mu m}$ |
| 25 | 40 | 4130 | $0,94.10^{-3}$ | 0,81 | $0,9.10^{-3}$ | 0,63(0,87) | 2,3 |
| 25 | 30 | 4230 | $0,95.10^{-3}$ | 0,75 | $0,95.10^{-3}$ | 0,66(0,87) | 2,0 |
| 20 | 40 | 4150 | $0,92.10^{-3}$ | 0,71 | $0,95.10^{-3}$ | 0,77(0,89) | 2,2 |
| 40 | 30 | 3640 | $1,2.10^{-3}$ | 0,76 | $10^{-3}$ | 0,76(0,87) | 2,3 |
| 50 | 30 | 3790 | $1,5.10^{-3}$ | 0,77 | | 0,75(0,87) | 2,6 |
| 50 | 40 | 4405 | $1,6.10^{-3}$ | 0,87 | $1,7.10^{-3}$ | | 2,8 |
| 200 | 20 | 4750 | $1,5.10^{-3}$ | 0,66 | $1,5.10^{-3}$ | 0,69(0,87) | 2,1 |
| 200 | 10 | 6130 | $0,7.10^{-3}$ | NM | $0,8.10^{-3}$ | NM | |
| 250 | 40 | 3700 | $4,1.10^{-3}$ | 0,87 | $4,1.10^{-3}$ | 0,69(0,87) | 4 |
| 250 | 20 | 3400 | $2,8.10^{-3}$ | -- | $2,5.10^{-3}$ | 0,66(0,87) | 3,1 |

Tableau 11

| Influence de la pression totale (puissance RF : 25 W)) | | | | | | | |
|---|---|---|---|---|---|---|---|
| | | | ITGO sur verre | | ITGO sur polymère | | |
| Pression totale mbar | %$O_2$ | Epaisseur A (verre) | Résistivité ($\Omega$cm) | T(0,8 $\mu$m) | Résistivité ($\Omega$cm) | T (0,63 $\mu$m) (et polymère seul) | $\lambda_{(R=T)\mu m}$ |
| $4.10^{-3}$ | 40 | 2640 | $3,4.10^{-3}$ | 0,75 | $1,7.10^{-3}$ | | 2,85 |
| $2.10^{-3}$ | 40 | 3860 | $1,2.10^{-3}$ | 0,82 | $1,3^{-3}$ | 0,64(0,87) | 2,6 |
| $10^{-3}$ | 40 | 4130 | $0,94.10^{-3}$ | 0,81 | $0,9.10^{-3}$ | 0,63(0,87) | 2,3 |
| $2.10^{-3}$ | 100 | 1470 | $22.10^{-3}$ | 0,86 | --- | --- | 2,6 |
| $5.10^{-3}$ | 100 | 4300 | $42.10^{-3}$ | | --- | --- | |
| $4.10^{-3}$ | 30 | 3020 | $2,35.10^{-3}$ | 0,73 | --- | | 2,7 |
| $10^{-3}$ | 30 | 4520 | $10^{-3}$ | 0,75 | $0,95.10^{-3}$ | 0,66(0,87) | 2,5 |

*Les paramètres de dépôts*

Les paramètres que les inventeurs ont fait varier sont les suivants :

- la ' pression totale dans l'enceinte. Les meilleurs dépôts sont obtenus à la pression la plus faible, c'est-à-dire $10^{-3}$ mbar.
- la pression partielle d'oxygène. Ils ont montré qu'il est préférable de travailler sous atmosphère d'$O_2$ pour pouvoir

contrôler la concentration en lacunes qui influent à la fois sur la conductivité et sur la transparence. Si les lacunes sont trop nombreuses, la conductivité est élevée mais la transparence est très mauvaise. Si le film est trop oxydé, la transparence est bonne mais la conductivité mauvaise car les ions étain sont piégés par l'oxygène et ne participent pas efficacement à la conduction. Cette pression partielle dépend fortement de la puissance du plasma. Ainsi, à 25 W, la pression partielle optimale se situe entre 30 et 40% alors qu'elle n'est que de 10 à 20% à 200 W.

- la puissance RF. Une tension RF est appliquée au plasma de façon à éviter l'accumulation de charges sur le substrat. Plus la puissance est augmentée, plus le plasma est efficace et plus les ions qui viennent bombarder le substrat sont énergétiques. Un équilibre s'établit entre les atomes qui sont déposés sur le substrat et ceux qui sont pulvérisés par le plasma. Les résultats expérimentaux montrent que les meilleurs dépôts sont obtenus à des puissances relativement faibles (20 à 40 W). Les mêmes puissances qu'en pulvérisation magnétron RF sont d'ailleurs retrouvées. Un plasma trop réactif (puissance < 100 W) nuit aux qualités optiques des dépôts. Au-delà de 300 W, le polymère se décompose.
- la vitesse de dépôt. Elle dépend à la fois de la puissance du canon, c'est-à-dire du nombre d'atomes évaporés et de la puissance RF, c'est-à-dire du nombre d'atomes repulvérisés par le plasma. Généralement, elle se situe entre 1 et 4 A/s.

*Comparaison entre les dépôts sur verre et sur polymère*

Avec les meilleurs films obtenus, les inventeurs ont réalisé les spectres en transmission et en réflexion sur verre et sur polymère. Ils ont comparé les spectres de transmission sur verre et sur polymère en faisant le rapport entre la transmission du PEEK seul et la transmission du PEEK avec le film d'ITGO. Les résultats expérimentaux montrent que la transmission (totale) sur polymère n'est pas altérée par rapport à celle du verre.

En ce qui concerne la réflexion, il faut prendre en compte le fait que le dépôt sur polymère diffuse partiellement la lumière. Son spectre est donc réalisé en réflexion totale alors que celui sur verre est généralement obtenu en réflexion spéculaire. Le résultat important est que le niveau de réflectivité reste semblable sur verre et sur polymère. Toutefois, les résultats expérimentaux montrent qu'il est encore plus faible que celui de l'ITGO réalisé sur verre par pulvérisation magnétron.

Les couches de silice peuvent également être réalisées par évaporation au canon à électrons assistée par plasma. L'épaisseur de ces couches de silice est de 0,1 µm pour essayer d'obtenir un effet antireflet maximum à 0,7-0,8 µm.

Empilements ITGO/SiO$_2$

Différents empilements bicouches ont été réalisés sur substrats PET et verre à des températures inférieures à 80°C en utilisant pour l'ITGO les conditions expérimentales optimisées décrites dans le paragraphe 4.2.1. Les différents résultats sont regroupés dans les tableaux 12 et 13 suivants.

Tableau 12

| empilement SiO$_2$/ITGO 1%Sn/0,2% Ge | | | | |
|---|---|---|---|---|
| Substrat | Verre | | PET | |
| Epaisseur ITGO | 455 nm | | 455 nm | |
| Conditions de dépôts | 40%O$_2$/<50°C/10$^{-3}$mbar/ 0,15W.cm$^{-2}$ | | 40%O$_2$/<50°C/10$^{-3}$mbar/ 0,15W.cm$^{-2}$ | |
| Vitesse de dépôt | 0,15 nm/s | | 0,15 nm/s | |
| Epaisseur SiO$_2$ | 104 nm | | 104 nm | |
| Conditions de dépôts | 10%0$_2$/<50°C/10$^{-3}$mbr/ 15W.cm$^{-2}$ | | 10%0$_2$/<50°C/10$^{-3}$mbar/ 15W.cm$^{-2}$ | |
| Vitesse de dépôt | 0,1 nm/s | | 0,1 nm/s | |
| | ITGO | ITGO/SiO$_2$ | ITGO | ITGO/SiO$_2$ |
| R(10 µm) | 0,77 | 0,77 | 0,76 | 0,75 |
| T(0,8 µm) | 0,84 | 0,85 | 0,8 | 0,86 |
| T$_{sol}$ | 65,4% | 67,3% | 61,6% | 68,5% |
| $\lambda_{(r=T)}$ | 2,2 | 2,4 | 2 | 2,4 |

Tableau 13

| empilement SiO$_2$/ITGO 2,5%SnO$_2$/0,5% GeO$_2$ | | | | |
|---|---|---|---|---|
| Substrat | Verre | | PET | |
| Epaisseur ITGO | 467 nm | | 467 nm | |
| Conditions de dépôts | 40%O$_2$/<50°C/10$^{-3}$mbar/ 0,15W.cm$^{-2}$ | | 40%O$_2$/<50°C/10$^{-3}$mbar/ 0,15W.cm$^{-2}$ | |
| Vitesse de dépôt | 0,11 nm/s | | 0,11 nm/s | |
| Epaisseur SiO$_2$ | 102 nm | | 102 nm | |
| Conditions de dépôts | 10%0$_2$/<50°C/10$^{-3}$mbar/ 15W.cm$^{-2}$ | | 10%0$_2$/<50°C/10$^{-3}$mbar/ 15W.cm$^{-2}$ | |
| Vitesse de dépôt | 0,1 nm/s | | 0,1 nm/s | |
|  | ITGO | ITGO/SiO$_2$ | ITGO | ITGO/SiO$_2$ |
| R(10 μm) | 0,8 | 0,8 | 0,75 | 0,74 |
| T(0,8 μm) | 0,82 | 0,84 | 0,8 | 0,83 |
| T$_{sol}$ | 64,2% | 65,2% | 63,8% | 66,2% |
| λ$_{(r=T)}$ | 1,9 | 2,1 | 2,1 | 2,3 |

Ces résultats montrent les mêmes effets de la coche de silice sur les propriétés optiques de l'ITGO que pour les dépôts réalisés par pulvérisation à savoir un déplacement de λ$_{R=T}$ vers les grandes longueurs d'onde et une amélioration de la transmittance solaire intégrée. De même, l'amélioration des propriétés optiques est plus sensible quand le substrat est le polymère. Il faut noter également que les niveaux de transmission et de réflexion sont plus faibles qu'en pulvérisation. L'assistance du plasma ne peut pas totalement remplacer une activation thermique. Enfin, on peut remarquer que les dépôts sur polymères ont des performances optiques équivalentes à celles sur verre et, surtout, bien meilleures que celles sur polymères par pulvérisation RF.

Les inventeurs ont donc montré qu'il était possible d'obtenir des films transparents solaires et réflecteurs IR performants en déposant uniquement deux couches : un conducteur transparent et une couche bas indice. Les propriétés optiques ne varient pas en fonction du nombre de couches empilées mais en fonction de la composition de la couche conductrice, à savoir l'ITGO.

Ils ont également montré qu'il était possible de réaliser sur polymère des films présentant les mêmes propriétés électro-optiques que ceux déposés sur verre en utilisant le dépôt ionique. Ainsi, à froid, il est possible de réaliser des films ayant des réflectivités de près de 80% sur polymère pour des transparences visibles atteignant les 85%, ce résultat ne peut être obtenu par exemple par pulvérisation magnétron à basse température.

La présente invention fournit donc notamment un empilement ITGO/silice sur polymère par pulvérisation magnétron, par évaporation électronique et/ou par dépôt ionique, par évaporation électronique avec assistance ionique sur des substrats d'au moins 10x10 cm$^2$, et par pulvérisation ionique et assistance ionique sur des substrats d'au moins 10x10 cm$^2$.

## Revendications

**1.** Substrat de polymère recouvert au moins en partie d'un film conducteur transparent à base d'oxyde d'indium, d'oxyde d'étain et d'oxyde de germanium, dans lequel le rapport des concentrations en poids de SnO$_2$ sur GeO$_2$ dans le film est d'environ 1 à environ 10, et dans lequel l'oxyde d'étain représente d'environ 0,5% à environ 10% en poids dans le film, et l'oxyde de germanium représente d'environ 0,1% à environ 5% en poids dans le film.

**2.** Substrat de polymère selon la revendication 1, dans lequel le rapport SnO$_2$/GeO$_2$ est environ égal à 5.

**3.** Substrat de polymère selon la revendication 1, dans lequel les concentrations en % en poids sont les suivantes :

SnO$_2$ : 0,5 à 2,5%
GeO$_2$ : 0,1 à 0,5%

le reste étant de l'oxyde d'indium et des impuretés inévitables.

**4.** Substrat selon la revendication 1, comprenant en outre une couche de protection de type oxyde transparent diélectrique ayant un indice de réfraction plus faible que celui de l'ITGO dans la gamme de 0,3 à 3 μm.

**5.** Substrat selon la revendication 1 dans lequel le film de conducteur transparent a une épaisseur supérieure à 400 nm et inférieure ou égale à 1000 nm.

**6.** Substrat selon la revendication 5, dans lequel le film de conducteur transparent a une épaisseur de 400 à 500 nm.

**7.** Substrat selon la revendication 4, dans lequel la couche de protection est une couche de silice.

**8.** Substrat selon la revendication 7, dans lequel la couche de silice a une épaisseur d'environ 0,1 μm.

**9.** Substrat selon la revendication 1, dans lequel le substrat a une surface d'au moins 10x10 cm$^2$.

**10.** Produit électrooptique comprenant un substrat selon l'une quelconque des revendications 1 à 9.

**11.** Utilisation d'un substrat selon l'une quelconque des revendications 1 à 9 pour la fabrication d'une protection électromagnétique.

**12.** Procédé de fabrication d'un substrat selon la revendication 1, **caractérisé en ce que** le film d'oxydes d'indium, d'étain et de germanium est déposé sur le substrat par une technique par dépôt physique en phase vapeur.

**13.** Procédé de fabrication d'un substrat selon la revendication 7, **caractérisé en ce que** le film d'oxydes d'indium, d'étain et de germanium (ITGO) est déposé sur le substrat par le procédé de la revendication 12, et la couche de silice est déposée sur le film d'ITGO par dépôt physique en phase vapeur.

**14.** Procédé de fabrication selon la revendication 12 ou 13, dans lequel la technique de dépôt physique en phase vapeur est choisie parmi une technique par pulvérisation ou une technique par évaporation.

**Patentansprüche**

**1.** Polymersubstrat, wenigstens zum Teil bedeckt mit einem transparenten leitfähigen Film auf der Basis von Indiumoxid, Zinnoxid und Germaniumoxid, in welchem das Verhältnis der Gewichtskonzentrationen von $SnO_2$ zu $GeO_2$ im Film ungefähr 1 bis ungefähr 10 ist und in welchem das Zinnoxid ungefähr 0,5 Gew.-% bis ungefähr 10 Gew.-% im Film darstellt und das Germaniumoxid ungefähr 0,1 Gew.-% bis ungefähr 5 Gew.-% im Film darstellt.

**2.** Polymersubstrat nach Anspruch 1, in welchem das Verhältnis $SnO_2/GeO_2$ ungefähr gleich 5 ist.

**3.** Polymersubstrat nach Anspruch 1, in welchem in Gew.-% die Konzentrationen die folgenden sind:

| | |
|---|---|
| $SnO_2$ | 0,5 bis 2,5% |
| $GeO_2$ | 0,1 bis 0,5%, |

während der Rest Indiumoxid und unvermeidliche Verunreinigungen sind.

**4.** Substrat nach Anspruch 1, darüber hinaus eine Schutzschicht vom Typ eines transparenten dielektrischen Oxids enthaltend, das in dem Bereich von 0,3 bis 3 μm einen kleineren Brechungsindex als ITGO hat.

**5.** Substrat nach Anspruch 1, in welchem der transparente Leiterfilm eine Dicke größer als 400 nm und kleiner als oder gleich 1000 nm hat.

**6.** Substrat nach Anspruch 5, in welchem der transparente Leiterfilm eine Dicke von 400 bis 500 nm hat.

**7.** Substrat nach Anspruch 4, in welchem die Schutzschicht eine Schicht von Siliciumdioxid ist.

**8.** Substrat nach Anspruch 7, in welchem die Schicht von Siliciumdioxid eine Dicke von ungefähr 0,1 μm hat.

**9.** Substrat nach Anspruch 7, in welchem die Schicht von Siliciumdioxid eine Oberfläche von wenigstens 10x10 cm$^2$ hat.

**10.** Elektrooptisches Erzeugnis, umfassend ein Substrat nach einem der Ansprüche 1 bis 9.

**11.** Verwendung eines Substrats nach einem der Ansprüche 1 bis 9 für die Herstellung eines elektromagnetischen Schutzes.

**12.** Verfahren zur Herstellung eines Substrats nach Anspruch 1, **dadurch gekennzeichnet, dass** der Film von Indium-, Zinn- und Germaniumoxiden mit einer Technik durch physikalische Abscheidung in der Gasphase auf dem Substrat abgeschieden wird.

**13.** Verfahren zur Herstellung eines Substrats nach Anspruch 7, **dadurch gekennzeichnet, dass** der Film von Indium-, Zinn- und Germaniumoxiden (ITGO) durch das Verfahren des Anspruchs 12 auf dem Substrat abgeschieden wird und die Schicht von Siliciumdioxid durch physikalische Abscheidung in der Gasphase auf dem Film von ITGO abgeschieden wird.

**14.** Herstellungsverfahren nach Anspruch 12 oder 13, in welchem die Technik der physikalischen Abscheidung in der Gasphase unter einer Technik durch Zerstäubung und einer Technik durch Aufdampfung ausgewählt ist.

**Claims**

**1.** Polymer substrate at least partially covered with a transparent conductor film with a base of indium oxide, tin oxide, and germanium oxide, in which the ratio of concentrations in weight of $SnO_2$ to $GeO_2$ in the film is between approximately 1 and approximately 10, and in which the tin oxide represents approximately 0.5% to approximately 10% of weight in the film and the germanium oxide represents approximately 0.1% to approximately 5% of weight in the film.

**2.** Polymer substrate according to claim 1, in which the ratio $SnO_2/GeO_2$ is approximately equal to 5.

**3.** Polymer substrate according to claim 1, in which the concentrations in percentage of weight are as follows :

$SnO_2$ : 0.5 to 2.5%
$GeO_2$ : 0.1 to 0.5%

the rest being indium oxide and inevitable impurities.

**4.** Substrate according to claim 1, furthermore comprising a transparent dielectric protection layer of the oxide type having a refraction index weaker than that of ITGO in the range 0.3 to 3μm.

**5.** Substrate according to claim 1, in which the transparent conductor film has a thickness greater than 400nm and less than or equal to 1000nm.

**6.** Substrate according to claim 5, in which the transparent conductor film has a thickness of 400 to 500nm.

**7.** Substrate according to claim 4, in which the protection layer is a silica layer.

**8.** Substrate according to claim 7, in which the silica layer has a thickness of approximately 0.1 μm.

**9.** Substrate according to claim 1, in which the substrate has an area of at least 10x10 cm$^2$.

**10.** Electro-optic product comprising a substrate according to any of claims 1 to 9.

**11.** Use of a substrate according to any of claims 1 to 9 for the production of electromagnetic protection.

**12.** Method for producing a substrate according to claim 1, **characterised in that** the film of indium, tin and germanium oxides is deposited on the substrate by physical vapour deposition.

13. Method for producing a substrate according to claim 7, **characterised in that** the film of indium, tin and germanium oxides (ITGO) is deposited on the substrate by the method in claim 12, and the silica layer is deposited on the ITGO film by physical vapour deposition.

14. Method of production according to claim 12 or 13, in which physical vapour deposition is chosen from a pulverisation technique or an evaporation technique.